# EUROPEAN PATENT APPLICATION

(11) **EP 4 145 498 A1**
(43) Date of publication of application: **08.03.2023**
(21) Application number: 21195319.5
(22) Date of filing: 07.09.2021
(51) Int. Cl.: H01L 21/768, H01L 23/528

(54) **STAGGERED INTERCONNECTION STRUCTURE**

(71) Applicant: Imec VZW, 3001 Leuven (BE)
(72) Inventor: TAO, Zheng, 3001 Heverlee (BE); DECOSTER, Stefan, 3060 Bertem (BE)
(74) Representative: AWA Sweden AB

(57) **Abstract**

A method for forming an interconnection structure (100) for a semiconductor device is disclosed, comprising forming a conductive layer (110) on an insulating layer (120), etching the conductive layer to form a first set of conductive lines (101), forming a first set of spacer lines (130) on sidewalls of the first set of conductive lines, and forming a second set of conductive lines (102) in trenches (140) defined by the first set of spacer lines, wherein a bottom (142) of the trenches is recessed into the insulating layer, or formed by a spacer material (150) arranged on the insulating layer, such that a bottom portion of the first set of conductive lines and a bottom portion of the second set of conductive lines are arranged on different vertical levels (H1, H2).

## Description

### Technical field

The present inventive concept relates to a method for forming an interconnection structure.

### Background

Modern circuit fabrication typically includes processes of forming electrical interconnection structures for interconnecting semiconductor devices in a functioning circuit. An interconnection structure may include one or more interconnection levels or tiers, which may be formed above the active device region. An interconnection level includes horizontal conductive paths or lines arranged in an insulating material layer. Conductive lines of different interconnection levels may be interconnected by conductive vias extending vertically through the insulating layers.

Each conductive line may be dielectrically spaced from neighboring conductive lines within the same interconnection level by a certain distance, which together with the electrical permittivity of the insulating material may determine the intra-level capacitance C, or parasitic capacitance, between the conductive lines. The capacitance may together with the resistance R of the conductive line determine the propagation delay, or RC delay, which reflects the speed (frequency) at which the circuit can operate. RC delay risks becoming a major obstacle to continued downward scaling of semiconductor circuits, which relies on ever more aggressive lines pitches.

### Summary

An objective of the present inventive concept is thus to provide a method for forming interconnection structures allowing for tight-pitch conductive lines. A further objective is to enable forming of interconnection structures in a manner that allows for problems with RC delay to be reduced or at least alleviated. Further and alternative objectives may be understood from the following.

According to an aspect of the present inventive concept there is provided a method for forming an interconnection structure for a semiconductor device, the method comprising:
forming a conductive layer on an insulating layer,
etching the conductive layer to form a first set of conductive lines,
forming a first set of spacer lines on sidewalls of the first set of conductive lines, and
forming a second set of conductive lines in trenches defined by the first set of spacer lines.

A bottom of the trenches may be recessed into the insulating layer or formed by a spacer material arranged on the insulating layer, such that a bottom portion of the first set of conductive lines and a bottom portion of the second set of conductive lines are arranged on different vertical levels. Further, a top surface of the first set of conductive lines is arranged on a first vertical level, whereas a top surface of the second set of conductive lines is arranged on a second vertical level.

The present inventive concept allows forming of tight-pitch conductive lines, wherein the first set of conductive lines are arranged in a vertically staggered configuration with respect to the second set of conductive lines. Staggering the first and second sets of conductive lines on dissimilar elevational levels may advantageously reduce the parasitic capacitances between neighboring conductive lines.

Contrasting a conventional damascene-stye process in which the conductive lines are formed by the portions of the conductive material layer deposited in pre-patterned trenches, the inventive process forms the first set of conductive lines by etching the deposited conductive layer. The first set of conductive lines may accordingly be directly "printed" in the conductive layer, whereas spacers may be used for defining, and preferably self-aligning the second set of conductive lines.

With the present inventive process at least the bottom level of the first set of conductive lines may be arranged on a vertical level dissimilar to the bottom level of the second set of conductive lines. Further, in some examples the first set of conductive lines may have a top surface arranged on a vertical level that differs from the top surface of the second set of conductive lines.

Thus, by "staggered" may, for the purpose of the present application, be understood as something being arranged on different vertical levels. More specifically, the first set of conductive lines may be arranged on a vertical level that differs from the vertical level of the second set of conductive lines in respect of a bottom level, a top level, or both.

By "conductive layer" is generally meant a layer formed of an electrically conductive material. Non-limiting examples of suitable conductive materials include, *inter alia,* Ru, Mo, W, Al, and Co, as well as combinations thereof, and may preferably be possible to etch to form the first set of conductive lines from the first conductive layer.

By "spacers" is meant a layer arranged on sidewalls of a feature, such as the first set of conductive lines. The spacers may define a separating distance, such as a dielectric separation between the first and second set of conductive lines. Further, the spacers may form a sacrificial material which can be removed in the downstream process, for instance to form an air gap (air spacer).

By "horizontal" is generally understood a direction parallel to the main plane of extension of the layers and substrate onto which the semiconductor device is formed. Consequently, by "vertical" is generally understood the direction normal to the main surface of the layers and the substrate.

The bottom of the trenches, which are defined by the first set of spacer lines, may be recessed into the insulating layer, using the first set of spacer lines as an etch mask. The bottom of the trenches may be recessed into the insulating layer prior to forming the second set of conductive lines. Using the first set of spacer lines as an etch mask allows for the trenches to be self-aligned.

By the terminology "using a layer as an etch mask" is hereby meant that one or more underlying layers are etched while said layer counteracts etching of the underlaying layer(s) in regions covered by said layer. The underlying layer(s) may hence be etched selectively to said layer acting as an etch mask.

By etching a feature "A" of a first material, selectively to (i.e. with respect to) a feature "B" of a second material, is hereby meant exposing the features A and B to an etch process wherein the feature A is etched at a greater rate that the feature B. This may be achieved by selecting the material of feature A and the material of feature B as a combination of materials presenting different etch rates in the etch process. Hence, portions of the feature A exposed to the etching process may be removed while portions of the feature B exposed to the etch process may be preserved. The preservations of the feature B following the etch process may be complete (in the sense that the feature B is not affected appreciably during the etch process) or at least partial (in the sense that the feature B remains at least to the extent that it may serve its intended function during subsequent process steps).

By recessing the bottom of the trenches prior to forming the second set of conductive lines the bottom level of the second set of conductive lines may be arranged on a lower vertical level compared to the bottom level of the first set of conductive lines. An alternative way of achieving a similar difference in vertical orientation may be to recess the insulating layer between the first set of conductive lines prior to forming the first set of spacer lines. This may for example be achieved by means of an etch mask formed for this purpose, or by using the first set of conductive lines as an etch mask.

In an embodiment, the spacer material may be deposited on the insulating layer in the bottom of the trenches defined by the first set of spacer lines. The spacer material may for example be deposited to embed the first set of conductive lines and cover the insulating layer between the first set of conductive lines. The spacer material may be provided in a conformal layer or a non-conformal layer, wherein in case of the latter the spacer material may be deposited with a thickness that differs between the sidewalls of the first set of conductive lines and the insulating layer in the bottom of the trenches. The spacer material may for example be thicker on the insulating layer in the bottom of the trenches than on the sidewalls of the conductive lines.

By forming the spacer material on the insulating layer in the bottom of the trenches prior to forming the second set of conductive lines, the second set of conductive lines may be vertically offset in relation to the first set of conductive lines.

The second set of conductive lines may either be formed by a damascene-style process in which the trenches are filled with a conductive material, by another direct metal etch process, or by a spacer process in which the conductive material is formed as a second set of spacer lines on sidewalls of the first set of spacer lines. The damascene-style process and the dual direct metal etch may include an additional step of planarization, such as chemical-mechanical planarization (CMP) for removing excess material and planarizing the wafer surface.

The first and second set of conductive lines may be protected by a respective mask layer, such as a first mask layer for the first set of conductive lines and a second mask layer for the second set of conductive lines. The first mask layer may for example be formed prior to patterning the conductive layer, thereby defining the first set of conductive lines. Further, the second mask may be formed by recessing the second set of conductive lines and form the second mask in the recessed areas. The masks may protect the first and second set of conductive lines during subsequent processing, such as for example via formation. The first and second masks may be etch selective with respect to each other, for example allowing for the first set of conductive lines to be contacted from above in a self-aligned via formation process, while protecting the second set of conductive lines. The etch selectivity may allow for an improved overlay performance of the lithographic process. Further, in some examples the second mask may be a plug formed by the recess of the second conductive line followed by plug fill and CMP.

A first via hole, extending through the insulating layer to an underlying conductive structure, may be formed prior to forming the conductive layer. The conductive layer may thus be formed by depositing the conductive layer such that it fills the via hole and covers the insulating layer. When patterning the conductive layer, a first conductive line of the first set of conductive lines may be arranged to extend across the first via hole, thereby allowing the first conductive line to contact the first via hole. The first conductive line may thus extend at least partly into the first via so as to ensure an electrical connection between the via and the conductive line.

A second via hole, extending through the insulating layer to the underlying conductive structure, may be formed prior to the second set of conductive lines. Further, the second set of conductive lines may be formed by depositing a material, filling the second via hole and forming the second set of conductive lines. At least one of the conductive lines of the second set of conductive lines may hence be arranged to extend at least partly into the second via to ensure an electrical connection to the via.

In case the bottom level of the trenches is formed by the spacer material arranged on the insulating layer, the second via hole may be formed to extend through the spacer material and the insulating layer to the underlying conductive structure. In a subsequent step, the second set of conductive lines may be formed by depositing a material, filling the second via hole.

### Brief description of drawings

The above, as well as additional objects, features, and advantages of the present inventive concept, will be better understood through the following illustrative and non-limiting detailed description, with reference to the appended drawings. In the drawing like reference numerals will be used for like elements unless stated otherwise.
Figures 1-9b are cross sections illustrating process flows according to some methods for forming an interconnection structure.
Figures 10-12 are cross sections illustrating process flows according to some alternative methods for forming an interconnection structure.
Figures 13-20b are cross sections illustrating process flows according to further methods for forming an interconnection structure.
Figures 21-26 are cross sections illustrating process flow according to further methods for forming an interconnection structure.

### Detailed description

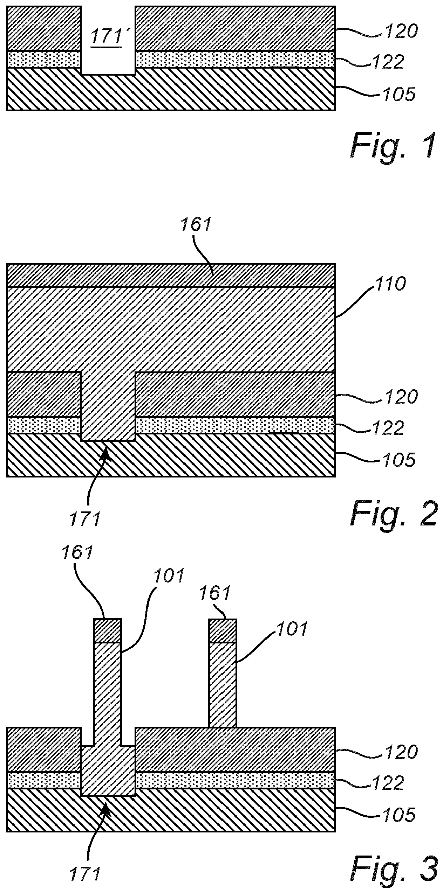

A method for forming an interconnection structure, suitable for instance for a semiconductor device, will now be described with reference to figures 1-9b.

With reference to figure 1 there is shown, in cross section, a portion of an intermediate structure or device. The structure may extend laterally or horizontally beyond the illustrated portion. The illustrated planes or layers extending through the structure are common to all the figures unless stated otherwise. It is noted that the relative dimensions of the shown elements, in particular the relative thickness of the layers, is merely schematic and may, for the purpose of illustrational clarity, differ from a physical structure.

The structure comprises an underlying conductive structure 105, onto which an insulating layer 120 is arranged. The conductive structure 105 may for example be referred to as a bottom metal layer 105 and may in some example form a buried interconnect or power rail. The insulating layer 120 may be formed of an electrically insulating material 120, typically a dielectric layer such as a layer of silicon oxide or some other conventional low-k dielectric layer. For instance, the insulating layer 120 may be a layer stack comprising, in addition to a low-k dielectric layer, an interface layer 122 and/or an oxide capping layer formed on an upper surface of the bottom metal layer 105. The insulating layer 120 may be deposited by chemical vapor deposition (CVD), as one example.

As illustrated in figure 1, a first via hole 171' may be formed, extending through the insulating layer 120 to the underlying conductive structure 105 and may accordingly expose a surface, typically an upper surface, of the underlying conductive structure 105. The first via hole 171' may be formed using a sequence of lithography and etching steps (a "litho-etch sequence"), for example including a dry etching process such as a reactive ion etch (RIE) or ion beam etching (IBE).

A litho-etch sequence may generally comprise forming a photoresist mask layer on the layer which will be patterned, i.e., the "target layer" (such as the insulating layer 120). A pattern (e.g. a pattern of openings, trenches or lines) may be lithographically defined in the photoresist layer and then transferred onto the target layer by etching while using the pattered photoresist layer as an etch mask. The photoresist layer may thereafter be stripped from the target layer. A litho-etch sequence may also comprise forming a lithographic mask layer stack (a "litho stack") on the target layer. The litho stack may comprise a patterning layer as a lower layer of the litho stack. The patterning layer may be an amorphous-carbon film, or some other conventional organic or non-organic patterning film allowing high-fidelity pattern transfer into the target layer in question. The litho stack may further comprise a photoresist layer and a set of transfer layers intermediate the patterning layer and the photoresist layer. The set of intermediate layers may comprise, for instance, one or more anti-reflective coatings such as SiOC layers, SOG layers and optionally a planarization layer such as an organic spin-on layer (e.g. a SOC layer). A pattern may be lithographically defined in the photoresist layer and subsequently transferred into lower layers of the litho stack, in a number of etch steps, and subsequently into the patterning layer. The pattern transfer process may cause a partial consumption of the litho stack layer stack. For instance, the photoresist layer may be consumed during the transfer process. The litho-etch sequence may conclude by etching the target layer while using the patterned patterning layer as an etch mask. Any remaining layers of the litho stack may thereafter be stripped from the target layer.

In figure 2, a conductive layer 110 has been formed on the insulating layer 120. The conductive layer 110 may be deposited to fill the first via hole 171' and cover the insulating layer 120. The conductive layer portions filling the first via hole 171' define a vertical conductive via structure 171 providing electrical access to the underlying conductive structure 105. The conductive layer 110 may be formed to present a thickness above an upper surface of the insulating layer 120 corresponding to a desired height of the conductive lines which are to be formed.

The conductive layer 110 may be a metal layer, for instance a layer of ruthenium (Ru). Other examples of the conductive layer include a layer of molybdenum (Mo), tungsten (W), aluminum (Al) and cobalt (Co), and alloys thereof. Preferably, a metal is used which is suitable for patterning by means of metal etching, rather than damascene-style processes. The conductive layer 120 may be deposited by CVD or atomic layer deposition (ALD). The conductive layer 120 may also be deposited by physical vapor deposition (PVD) or electroplated. The conductive layer 110 may be a single metal of the aforementioned materials, or a multilayer combining two or more metals deposited with the same or different methods among the ones just cited.

A first mask layer 161 may be formed on the conductive layer 110. The first mask layer 161 may for example be a hard mask composed of silicon oxide (SiO₂), silicon nitride (SiN), silicon carbon nitride (SiCN or silicon carbide (SiC). It will however be appreciated that other materials could be used as well, such as spin-on oxide, and conductive materials which may be removed in later processing steps. The first mask may be used as an etch mask for forming the first set of conductive lines 101 from the conductive layer 110. The result is shown in figure 3, illustrating a pair of first conductive lines 101 which have been formed by a metal etch process, also referred to as a direct metal etch. In the present example, the conductive layer 120 has been somewhat over-etched to ensure a complete removal of the portions of the conductive layer 120 which are not protected by the first mask 161. As a result, the conductive layer 120 is slightly recessed into the first via hole 171'.

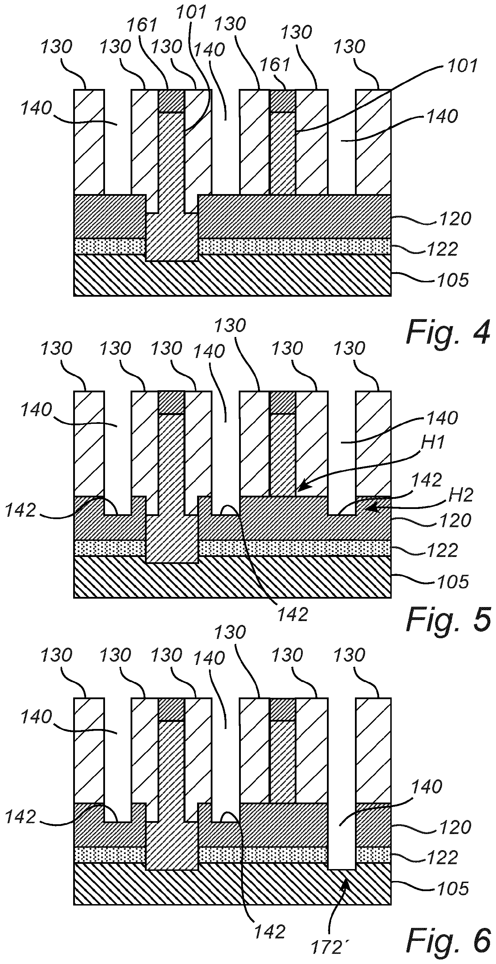

In figure 4, a first set of spacer lines 130 has been formed on sidewalls of the first set of conductive lines 101. The first set of spacer lines 130 may be formed of a layer of a carbon-comprising material or a silicon-comprising material, such as amorphous carbon, polysilicon, amorphous silicon, silicon oxide, silicon nitride, or silicon carbide, which may be deposited for instance by CVD or ALD. The deposition may be of an isotropic nature, resulting in a substantially conformal layer having the same thickness in all directions. Alternatively, the deposition may be of a more anisotropic nature, in which the thickness of the resulting layer may vary in the horizontal and the vertical directions. In the structure illustrated in figure 4 any spacer material on horizontal surfaces has been etched or recessed, leaving the spacers 130 on the sidewalls of the first set of conductive lines 101.

Trenches 140 may be defined between spacers 130 of neighboring conductive lines 101, having a width defined by the thickness of the spacers 130.

As illustrated in figure 5, the bottom 142 of these trenches 140 may be recessed into the insulating layer 120. The recessing may for instance include dry etching, using the first set of spacer lines 130 as an etch mask. Thus, the bottom portions 142 of the trenches 140 may be recessed in a self-aligned manner. The resulting structure is shown in figure 5, wherein the trenches 140 are recessed to a vertical level H2 arranged below the vertical level H1 of the bottom portion of the first set of conductive lines 101.

In figure 6 a second via hole 172' has been formed in one of the trenches 140. The second via hole 172' may be formed by etching through the insulating layer 120 and the capping layer 122 to expose the underlying conductive structure 105. The first set of spacer lines 130, defining the trench 140, may be used for self-aligning the second via hole 172' in a first direction between the spacer lines 130. The second via hole 172' may further be self-aligned in a second direction, orthogonal to the first direction, by a (predefined) mask structure formed by the capping layer 122.

The trenches 140 may be filled by a conductive material forming the second set of conductive lines 102. The material forming the second set of conductive lines 102 may be similar as the material forming the first set of conductive lines 101 and may thus be selected from a list consisting of Ru, Mo, W, AI and cobalt Co, as well as alloys thereof. The second set of conductive lines 102 may however be deposited by a method that differs from the one used for the first set of conductive lines 101. The second set of conductive lines 102 may preferably be formed by a damascene process, wherein a layer of conductive material is deposited to fill the trenches 140 and the second via hole 172', and then planarized by a chemical-mechanical planarization process (CMP). The second set of conductive lines 102 may therefore be formed of conductors which are not particularly suitable for direct etching, such as for instance Cu.

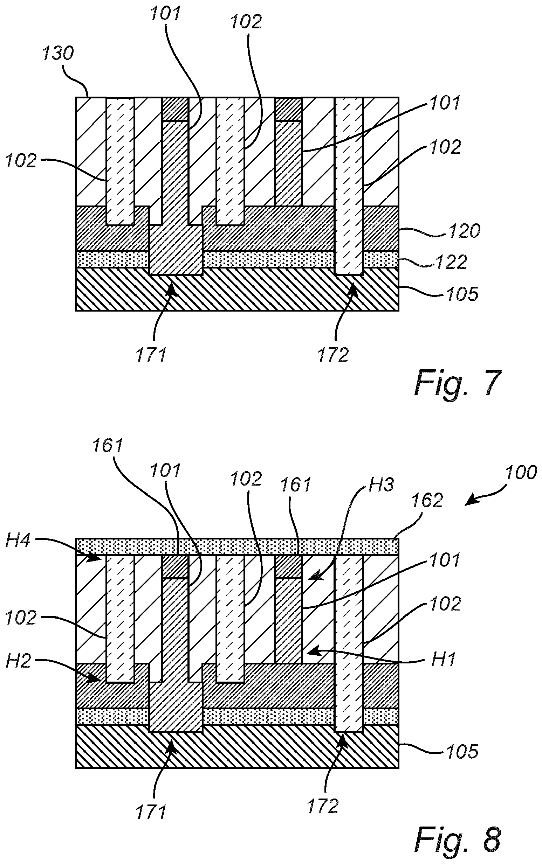

The resulting structure is shown in figure 7, wherein the second set of conductive lines 102 are formed in the trenches 140. Further, it can be noted that a first one of the first set of conductive lines 101 extends across the first via 171, and that a first one of the second conductive lines 102 extend across the second via 172, thereby providing a vertical interconnection to the underlying conductive structure 105.

It will however be appreciated that the second set of conductive lines 102 in an alternative process (not shown) may be formed as spacers on the sidewalls of the first set of spacer lines 101.

Figure 8 shows an implementation wherein a cap layer 162 has been deposited over the interconnection structure 100 formed by the first and second conductive lines 101, 102. In this example, the bottom level of the first set of conductive lines 101 and the bottom level of the second set of conductive lines 102 are arranged on different vertical levels H1, H2. Further, the top surfaces, or topmost levels of the first and second sets of conductive lines 101, 102 are arranged on different vertical levels, wherein the top surface of the first set of conductive lines 101 is arranged in a vertical level H3 that is below the vertical level H4 of the top surface of the second set of conductive lines 102. In different words, the first and second set of conductive lines 101, 102 may be considered as vertically staggered both in respect to their bottom and their top portions.

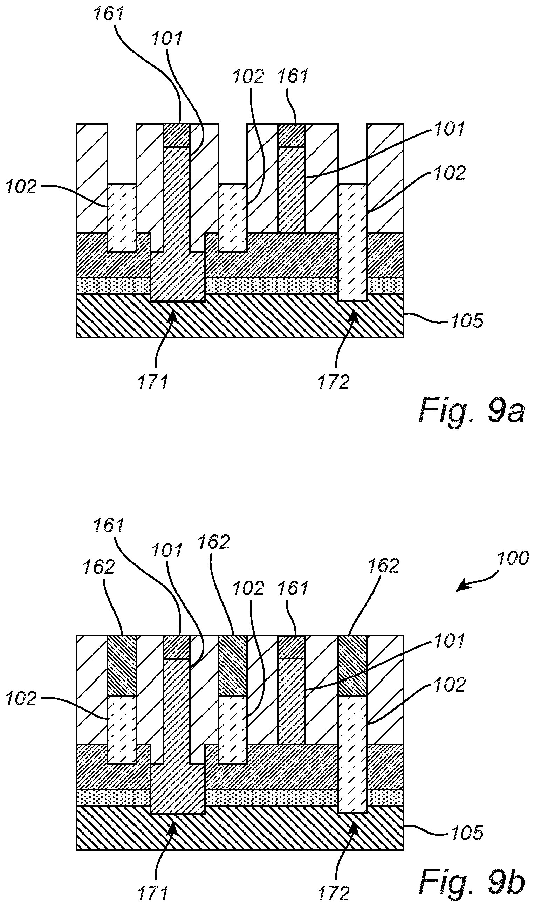

Figures 9a and 9b show an alternative to the structure in figure 8, wherein the second set of conductive lines 102 have been recessed to a level H4 below the top level H3 of the first set of conductive lines 101. The second set of conductive lines 102 may for example be recessed by a metal etch process, which may be self-aligned, using the first set of spacer lines 130 as an etch mask while the first set of spacer lines are protected by the first mask 161. A second mask 162 may then be deposited to encapsulate the second set of conductive lines 102, as indicated in figure 9b. The second mask 162 may for example be formed of a material different from the one of the first mask 161, preferably to provide an etch selectivity between the two mask types 161, 162. The etch-selectivity can be used in subsequent processing, for example to self-align further vias for selective contacting of the first or second set of conductive lines 101, 102.

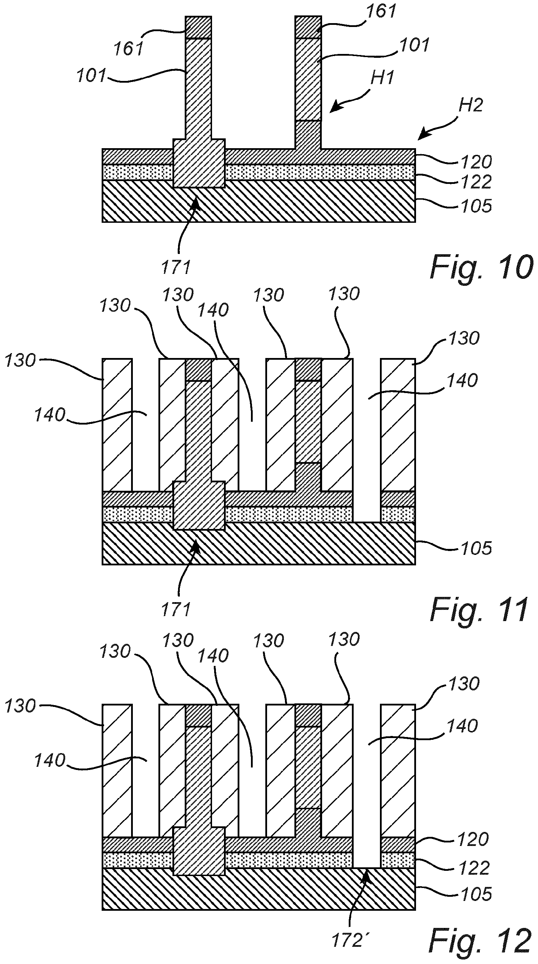

An alternative process flow will be discussed with reference to figures 10-12. Many of the features and steps of the above-mentioned method apply to this alternative process as well. In order to avoid undue repetition, reference will be made to the above for features and steps that are common for both process flows.

Thus, figure 10 shows a structure which may be provided by similar processing steps as the ones disclosed in connection with figures 1-3. A difference can however be noted in figure 10, relating to the insulating layer 120 which has been recessed between the first set of conductive lines 101 prior to forming the first set of spacer lines 130 on the sidewalls of the first set of conductive lines 101. The bottom level of the first set of conductive lines 101 may hence be arranged on a vertical level H1 that is above the vertical level H2 on which the surface of the recessed insulating layer 120 is arranged.

Figure 11 shows the structure after the first set of spacer lines 130 has been formed, and figure 12 shows the structure after the formation of the first via hole 172', which has been etched through the (recessed) insulating layer 120 and the capping layer 122 in a similar manner as discussed above with reference to figure 6. The remaining processing steps for forming the second set of conductive lines 102 and the first and second masks 161, 162 may be similar to the ones discussed in connection with figures 7-9b and will therefore not be repeated.

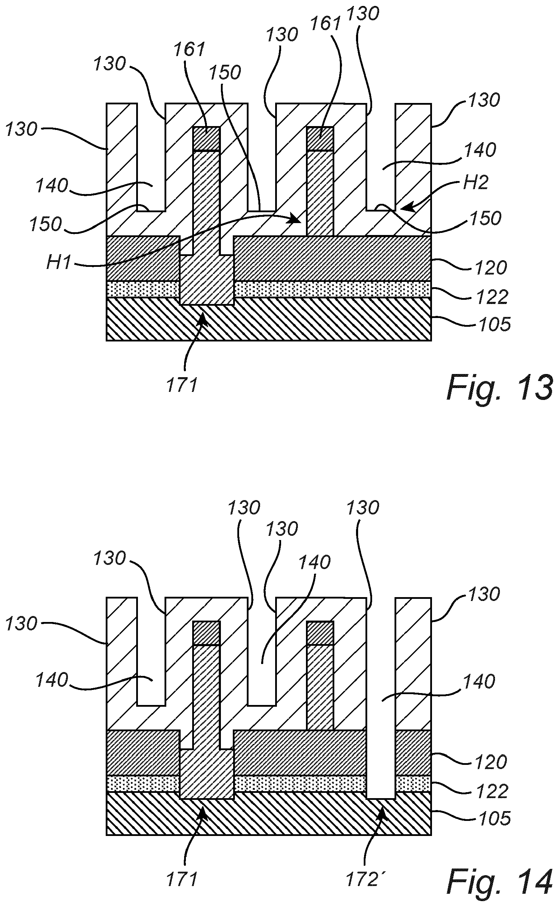

A further alternative process flow is shown in figures 13-20d. Similar to the above, many of the features and steps of the above-mentioned methods apply to this alternative process as well. In order to avoid undue repetition, reference will therefore be made to the above for features and steps that are common for all three process flows.

Thus, figure 13 show a structure which may be provided by similar processing steps as the ones disclosed in connection with figures 1-3. A difference can however be noted in figure 13, relating to the formation of the first set of spacer lines 130. In the present example, the first set of spacer lines 130 has been formed by depositing a layer 150 of insulating material substantially uniformly over the first set of conductive lines 101, including the first mask 161, and the insulating layer 120 between the conductive lines 101. In the present example the layer 150 may be substantially uniform, having a similar thickness on horizontal as well as vertical surfaces. Other alternatives, such as non-uniform layers, are however also possible.

As illustrated in figure 13 the bottom of the trenches 140, defined by the first set of sidewall spacer lines 130, may hence be arranged on a vertical level H2 that is above the vertical level H1 of the bottom part of the first set of conductive lines 101. This differs from the alternatives described in figures 1-9 and 10-12, wherein the trenches 140 instead are recessed into the insulating layer 120.

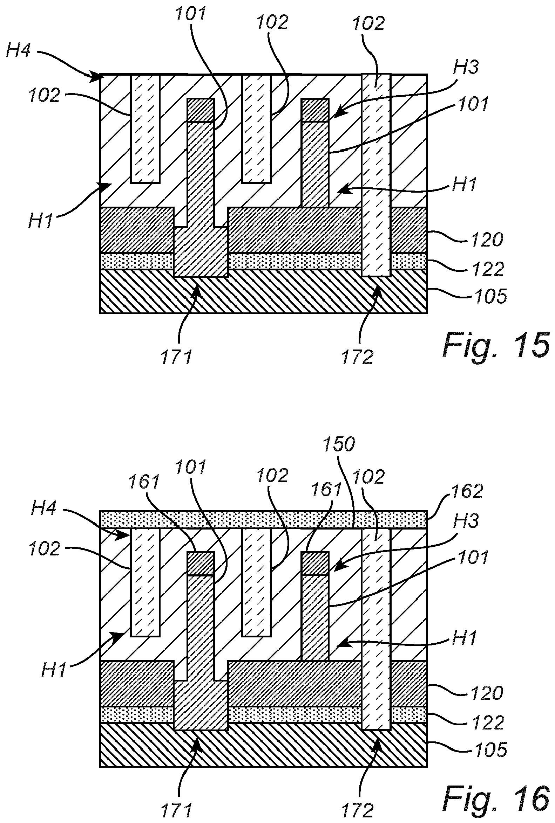

In figures 14 and 15 the second via 172 has been formed in a similar manner as described above, with the difference that the via hole 172' also extends through the insulating layer 150 arranged on the bottom of the trench 140.

Figure 16 shows an implementation similar to the one disclosed in figure 8, in which a cap layer 162 has been deposited over the interconnection structure 100 formed by the first and second conductive lines 101, 102. In this example however, the first and second set of conductive lines 101, 102 are staggered slightly differently. The bottom level H1 of the first set of conductive lines 101 is arranged below the bottom level H2 of the second set of conductive lines 102. Further, the top surface, or topmost level H3 of the first set of conductive lines 101 is arranged below the corresponding level H4 of the second set of conductive lines 102.

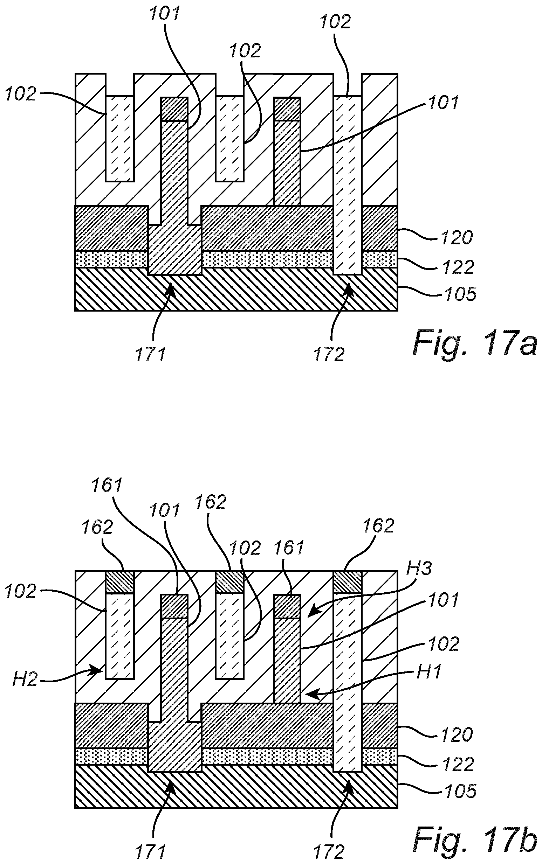

Figures 17a and 17b show an alternative to the structure in figure 16, similar to the one shown in figures 9a and 9b, wherein the second set of conductive lines 102 have been recessed and a second mask 162 formed in the recesses. Advantageously, the second mask 162 may be formed of a material different from the one of the first mask 161 to provide an etch selectivity between the two mask types 161, 162.

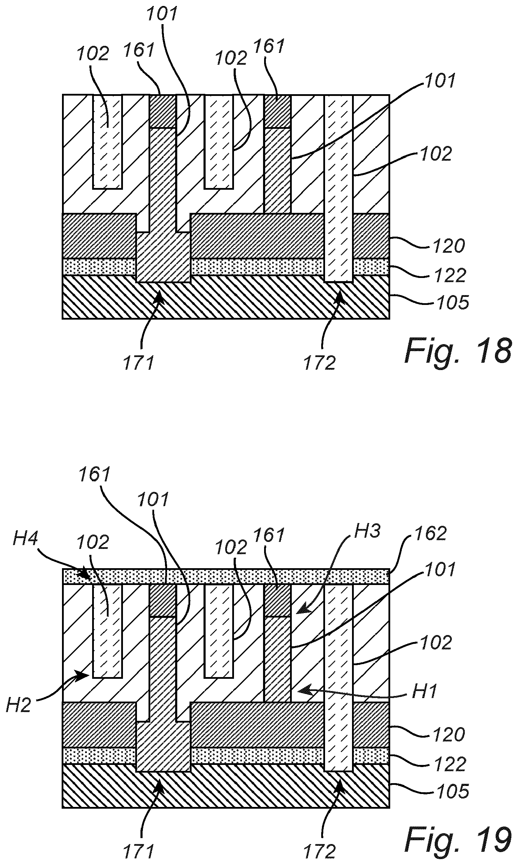

Figure 18 shows an alternative where the planarizing performed after the deposition of the second conductive lines 102 has been stopped on the first mask 161. As a consequence, the spacer material 150 has been recessed and preferably removed over the first set of conductive lines 101, exposing the first mask 161.

Similar to figure 16, a cap layer 162 may be deposited over the interconnection structure 100 as shown in figure 19.

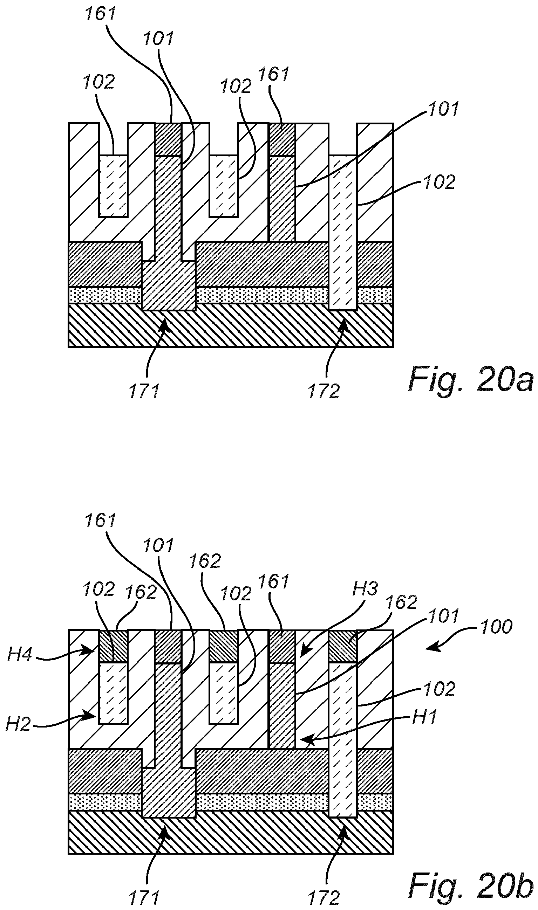

Alternatively, the second set of conductive lines 102 may be recessed and a second mask 162 formed in the recesses, as shown in figures 20a and 20b. This the structures in figures 20a and 20b may hence be similar to the structures shown in figures 17a and 17b.

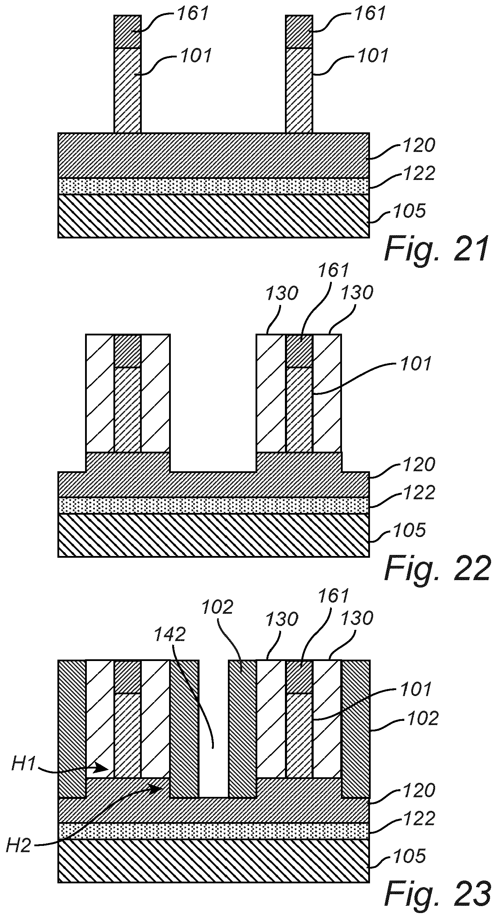

Figures 21-26 show further examples wherein the second set of conductive lines 102 may be formed by a spacer formation process. Thus, the second set of conductive lines 102 may be provided in the form of a second set of spacer lines 102 on sidewalls of the first set of spacer lines 130. Similar to the above-discussed embodiments, as illustrated in figures 1-20b, a staggered configuration, or height difference, between the first set of conductive lines 101 and the second set of conductive lines 102 may be provided in several ways. The second set of conductive lines can for instance be formed on a recess portion of the insulating layer 120, wherein the recess may be formed before or after the formation of the first set of spacer lines 130. In further examples, the second set of conductive lines 102 can be formed on a spacer material 150 arranged on the insulating layer.

With reference to figures 21-25, an exemplary process flow wherein the second set of conductive lines 102 are arranged as spacers on a recessed portion of the insulating layer 120 will now be described.

Figure 21 shows a structure similar to the one of for instance figure 3, comprising a first set of conductive lines 101 arranged on the insulating layer 120.

Figure 22 show the structure after formation of a first set of spacer lines 130 on sidewalls of the first set of conductive lines 101. The forming of the spacer lines 130 has been followed by a recess of the insulating layer 120 to allow for the second set of conductive lines 101 to be provided as spacers at a lowered bottom level H2, as shown in figure 23. Thus, the first set of conductive lines 101 may be arranged at a bottom level H1, which is elevated relative to the bottom level H2 of the second set of conductive lines 102.

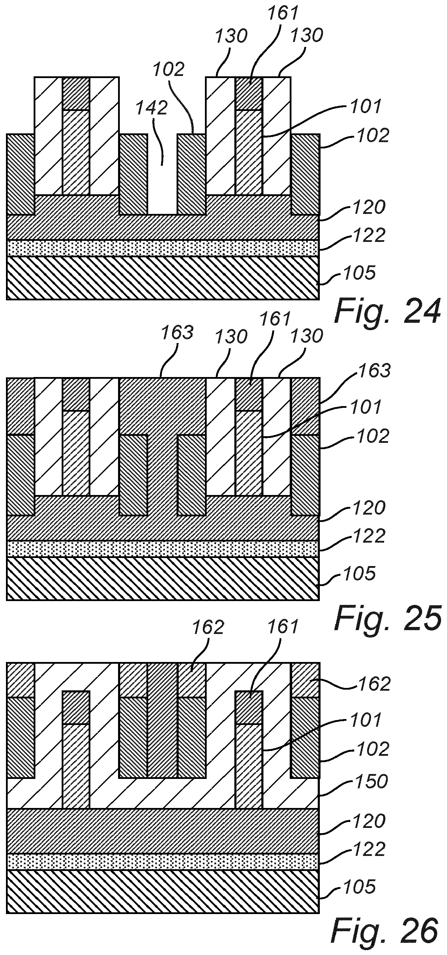

In figure 24 the second set of conductive lines 102 has been recessed to a vertical level below the vertical top level of the first conductive lines 101.

In figure 25 the trench 142 defined by the spacers forming the second set of conductive lines 102 has been filled with an insulating material 163, which for example may be the same as used for forming the first set of spacer lines 130. Other filling materials are however also possible, for example to enable etch selectivity to the first spacer lines 130. The plug, filling the trench 142, may be removed in subsequent processing steps so as to provide an air gap, or air spacer.

In figure 25 the gap 142 between the second set of conductive lines 102 has been filled with the material covering also the second set of conductive lines 102. In alternative examples, the gap may be filled prior to recessing the second set of conductive lines 102. One such example is shown in figure 26, wherein the second set of conductive lines 102 has been recessed and the recesses filled with another insulating (or mask) material 162, which may be etch selective to the gap filling material provided in the trench 142.

A further difference can be noted in the structure of figure 26, namely that the second set of conductive lines 102 has been formed on a portion of the insulating layer 120 that has been elevated or raised by means of a spacer material 150 arranged on the insulating layer 120, similar to the examples discussed above with reference to figures 13-20b.

The exemplary process flows disclosed in connection with figures 21-26 may be combined with the formation of via structures 171, 172 as discussed with reference to figures 1-20b. However, as will be appreciated by the skilled person, the second hole 172' may in those cases be formed in a process which it not self-aligned.

In the above the inventive concept has mainly been described with reference to a limited number of examples. However, as is readily appreciated by a person skilled in the art, other examples than the ones disclosed above are equally possible within the scope of the inventive concept, as defined by the appended claims. For instance, although the first and second via structures 171, 172 in the method described above with reference to figures 1-20b were formed together with the forming of the interconnection structure 100 comprising the first and second set of conductive lines 101, 102, the inventive method may in further embodiment be performed without forming the via structures. Thus, the etching and filling of the via holes, as indicated in the above figures, may as well be omitted. Further, any optional features and effects of the methods relying on a damascene-styled processing of the second set of conductive lines 102 may be combined with the methods relying on spacer-based processing of the second set of conductive lines 102.

## Claims

1. A method for forming an interconnection structure (100) for a semiconductor device, the method comprising:
forming a conductive layer (110) on an insulating layer (120);
etching the conductive layer to form a first set of conductive lines (101);
forming a first set of spacer lines (130) on sidewalls of the first set of conductive lines; and
forming a second set of conductive lines (102) in trenches (140) defined by the first set of spacer lines, wherein a bottom (142) of the trenches is recessed into the insulating layer, or formed by a spacer material (150) arranged on the insulating layer, such that a bottom portion of the first set of conductive lines and a bottom portion of the second set of conductive lines are arranged on different vertical levels (H1, H2);
wherein a top surface of the first set of conductive lines is arranged on a first vertical level (H3); and
wherein a top surface of the second set of conductive lines is arranged on a second vertical level (H4).

2. The method according to claim 1, comprising recessing the bottom of the trenches into the insulating layer, using the first set of spacer lines as an etch mask, prior to forming the second set of conductive lines, wherein the trenches are self-aligned by the first set of spacer lines.

3. The method according to claim 1, comprising recessing the insulating layer between the first set of conductive lines prior to forming the first set of spacer lines.

4. The method according to claim 1, comprising depositing the spacer material to embed the first set of conductive lines and cover the insulating layer between the first set of conductive lines.

5. The method according to any of the preceding claims, comprising forming the second set of conductive lines as a second set of spacer lines on sidewalls of the first set of spacer lines.

6. The method according to any of claims 1-4, wherein forming the second set of conductive lines comprises filling the trenches with a conductive material (112).

7. The method according to any of the preceding claims, wherein the first vertical level is different from the second vertical level.

8. The method according to any of the preceding claims, further comprising:
prior to patterning the conductive layer, forming a first mask (161) defining the first set of conductive lines;
recessing the second set of conductive lines; and
forming a second mask (162) covering the second set of conductive lines;
wherein the first mask and the second mask differ with respect to etch selectivity.

9. The method according to claim 1, further comprising:
prior to forming the conductive layer, forming a first via hole (171') extending through the insulating layer to an underlying conductive structure (105);
wherein forming the conductive layer comprises depositing the conductive layer to fill the via hole and cover the insulating layer; and
wherein patterning the conductive layer comprises forming a first conductive line of the first set of conductive lines extending across the first via hole.

10. The method according to claim 9, further comprising:
prior to forming the second set of conductive lines, forming a second via hole (172') extending through the insulating layer to the underlying conductive structure;
wherein forming the second set of conductive lines comprises depositing a material, filling the second via hole and forming the second set of conductive lines.

11. The method according to claim 9, further comprising:
prior to forming the second set of conductive lines, forming a second via hole extending through the spacer material and the insulating layer to the underlying conductive structure;
wherein forming the second set of conductive lines comprises depositing a material, filling the second via hole and forming the second set of conductive lines.

12. The method according to any of the preceding claims, wherein the conductive layer is formed of at least one of Ru, Mo, W, Al and Co.
